# EUROPEAN PATENT APPLICATION

(11) **EP 2 640 085 A1**
(43) Date of publication of application: **18.09.2013**
(21) Application number: 11840284.1
(22) Date of filing: 09.03.2011
(51) Int. Cl.: H04Q 1/02, H05K 5/06

(54) **TELECOMMUNICATION HOUSING**

(30) Priority: 12.11.2010 KR 20100112889
(71) Applicant: KMW Inc., Gyeonggi-do 445-813 (KR)
(72) Inventor: KIM, Yoon Yong, Suwon-si Gyeonggi-do 443-470 (KR); PARK, Nam Shin, Hwaseong-si Gyeonggi-do 445-982 (KR)
(74) Representative: Habermann, Hruschka & Schnabel
(86) International application number: PCT/KR2011/001638
(87) International publication number: WO 2012/063997

(57) **Abstract**

Provided is a communication box including a body, one side of which is opened, the opened side end of the body having a thickness of 0.5 to 2.5 mm, and a cover for sealing the opened side of the body. According to the communication box, in a structure in which a body and a cover are coupled to each other using screws, a thickness of a portion of the body at which the screws are not coupled is reduced, making it possible to increase an internal capacity of the communication box while maintaining an outer size thereof. Thus, the weight of a communication part is reduced, an internal space of the communication box is effectively utilized, and characteristics of the communication box are improved.

## Description

### Technical Field

The present invention relates to a communication box, and more particularly, to a communication box capable of improving communication characteristics.

### Background Art

A communication box generally includes cases for individual parts such as a filter and an antenna used in a wireless communication system and a case for embedding a combination of such individual parts.

Recently, while studies on mounting a plurality of individual parts inside a single box to substitute a communication base station have been in progress, there have been difficulties in integrating individual parts due to their large sizes and heavy weights.

In the case of a communication filter as an example of an individual part, since an interior space of its box is used either for a communication signal or as a transmission path of a communication signal, a body and a cover are coupled to each other using a plurality of screws so as to firmly attach the cover to the body, thereby preventing leakage of a signal.

However, cases for individual parts are designed to have a thickness greater than a predetermined value to secure safety when screws are coupled to the box.

For example, when the diameter of a screw is 3 mm, a box is required to have a tip end having a thickness of 4 to 4.5 mm or more.

Accordingly, an internal capacity of a box is small compared to the outer size of the box, and although a structure having a complex geometry needs to be arranged within the box to realize desired characteristics of a filter and the like, there has been difficulty in arranging the structure due to its relatively small internal capacity.

Also, in the case of a communication filter, although its characteristics such as a resonance (Q) are improved by making an internal capacity of a box larger, it is not easy to increase the internal capacity to enhance the resonance of the filter since the outer size of the filter is generally limited by its installation area.

In order to improve such characteristics, a conventional box for a communication filter can be plated with silver, but this increases manufacturing costs.

Moreover, in the case of a box for a communication filter, although a cover is coupled to a body using screws so as to be completely attached to the body, a fine gap may be formed between the body and the cover in a region between the screws, causing passive inter-modulation distortion (PIMD) due to contact nonlinearity.

### Disclosure

### Technical Problem

Accordingly, the present invention has been made to solve the above-mentioned problems occurring in the prior art, and the present invention provides a communication box that can increase an internal capacity while maintaining the same outer appearance.

The present invention also provides a communication box that improves characteristics of a mobile communication part due to an increase in an internal capacity thereof and shows excellent characteristics relative to a conventional mobile communication device plated with silver even if it is not plated at all or is plated with an inexpensive material.

The present invention further provides a communication box that avoids generation of contact nonlinearity of a body and a cover thereof, thereby preventing deterioration of characteristics of a mobile communication part.

### Technical Solution

In accordance with an aspect of the present invention, there is provided a communication box including: a body, one side of which is opened, the opened side end of the body having a thickness of 0.5 to 2.5 mm; and a cover for sealing the opened side of the body.

A plurality of screws coupling portions thicker than the opened side end of the body may be provided in the body.

The communication box may further include steps or uneven surface enmeshed with each other provided between the body and the cover.

The communication box may further include a groove into which an end of the body is inserted.

The communication box may further include a metal seal softer than the body and the cover between the body and the cover.

The body and the cover may be bonded to each other by a sealing layer having a melting point lower than those of the body and the cover.

### Advantageous Effects

According to a communication box of the present invention, in a structure in which a body and a cover are coupled to each other using screws, a thickness of a portion of the body where the screws are not coupled is reduced, making it possible to increase an internal capacity of the communication box while maintaining an outer size thereof. Thus, the weight of a communication part can be reduced, an internal space of the communication box can be effectively utilized, and characteristics of the communication box can be improved.

Also, according to the communication box of the present invention, the communication box may not be plated due to an increase in internal capacity of the communication box or may be plated with an inexpensive metal such as copper while exhibiting excellent characteristics, making it possible to reduce manufacturing costs.

Moreover, according to the communication box of the present invention, contact nonlinearity can be avoided when screws are coupled using a pattern provided at a contact portion of the body and the cover to prevent contact nonlinearity, making it possible to prevent deterioration of characteristics. In particular, the cover is sealedly fixed to the body through a method of sealedly bonding the body and the cover, for example, lead bonding or laser welding, making it possible to manufacture the communication box without using screws, to reduce manufacturing costs, and enhance productivity.

### Description of Drawings

The above and other aspects, features and advantages of the present invention will be more apparent from the following detailed description taken in conjunction with the accompanying drawings, in which:
FIG. 1 is a perspective view of a communication box according to an embodiment of the present invention;
FIG. 2 is an exploded perspective view of the communication box according to the embodiment of the present invention;
FIG. 3 is a view illustrating a modification of a screw coupling portion of FIG. 2; and
FIGS. 4 to 9 are sectional views of communication boxes according to other embodiments of the present invention.

| | | | |
|---|---|---|---|
| 10: | body | 11: | screw coupling portions |
| 20: | cover | 21: | coupling holes |
| 30: | screw | 40: | seal |
| 50: | sealing layer | 60: | coupling bosses |

### Mode for Invention

Hereinafter, communication boxes according to exemplary embodiments of the present invention will be described in detail with reference to the accompanying drawings.

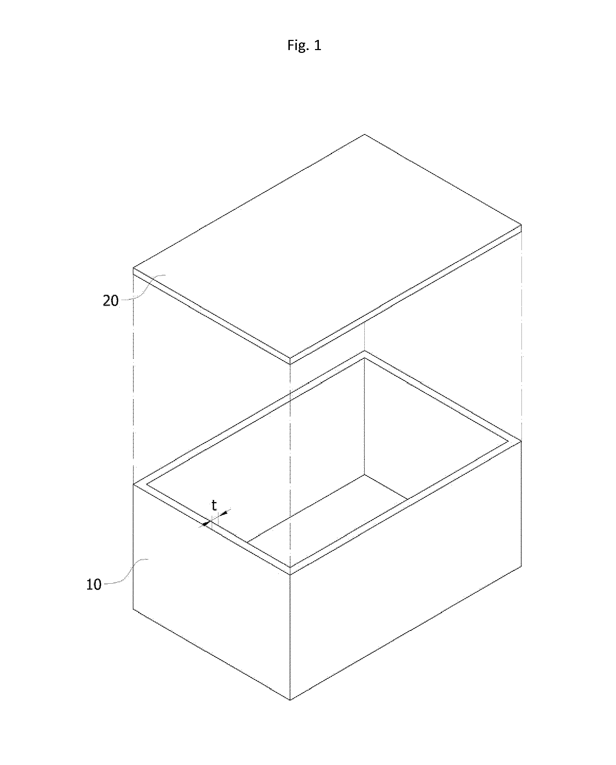

FIG. 1 is a perspective view of a communication box according to an embodiment of the present invention.

Referring to FIG. 1, the communication box according to the embodiment of the present invention includes a body 10 having a box-shaped structure, one side of which is opened such that a thickness (t) of an end thereof on the opened side is 0.5 to 2.5 mm, and a plate-shaped cover 20 for covering and sealing the opened side of the body 10.

The structure of the body 10 maximizes an internal space of the communication box, and an opened side end of the body 10 is made thinner so as to have a thickness (t) of 0.5 to 2.5 mm, making it possible to increase a flatness of an end thereof while it is being machined and hence improve a sealed state between the body 10 and the cover 20.

The thickness of the body 10 is made thin so that temperature can be uniformly distributed in the entire body 10 when the body 10 is heated, making it possible to couple the cover 20 to the body 10 while maintaining a sealed state between the body 10 and the cover 20 in various ways and to easily machine a mechanical structure for maintaining a sealed state when the cover 20 is coupled to the body 10.

The cover 20 may be fixed to the body 10 in various structures or through various methods while maintaining the sealed state between the body 10 and the cover 20, and various embodiments for fixing the cover 20 to the body 10 while maintaining the sealed state between the body 10 and the cover will be described below.

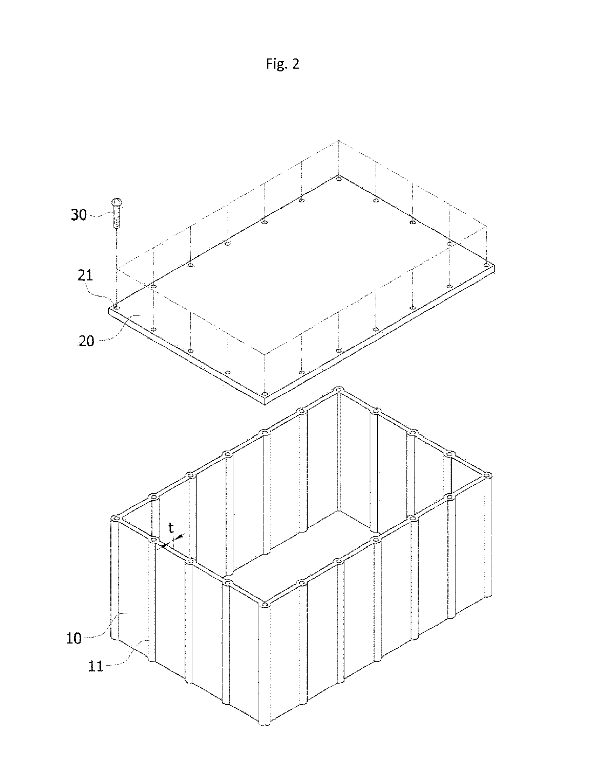

FIG. 2 is an exploded perspective view of the communication box according to the embodiment of the present invention.

Referring to FIG. 2, the communication box according to the embodiment of the present invention includes an open-topped box-shaped body 10 whose thickness (t) is 0.5 to 2.5 mm at portions other than a plurality of screw coupling portions 11, a cover 20, a plate-shaped cover 20 for covering and sealing the opened top side of the body 10, and a plurality of screws 30 for coupling a plurality of coupling holes 21 formed in the cover 20 and the screw coupling portions 11.

Hereinafter, the configuration and operation of the communication box according to the embodiment of the present invention will be described in detail.

First, the body 10 and the cover 20 may be made of a metal such as an aluminum alloy or a magnesium alloy.

The body 10 has an open-topped box-shaped structure and the cover 20 is positioned on and sealedly coupled to the opened side of the body 10. The plurality of screw coupling portions 11 are formed on a surface of the body 10 contacting the cover 20, and a thickness (t) of an end of the body 10 contacting the cover 20 is 0.5 to 2.5 mm at portions other than the screw coupling portions 11 irrespective of the thickness of the screws 30.

The screw coupling portions 11 are formed around coupling holes of the body 10 into which the screws 30 are inserted and coupled so as to have a thickness of 0.5 to 1 mm and be surrounded by the body 10. When the diameter of the screws 30 is 3 mm, the total thickness of the screw coupling portions 11 is at least 4 to 5 mm.

Although the thickness (t) of the end of the body 10 conventionally has to be 4 to 5 mm to couple the screws, the present invention can remarkably reduce the thickness.

The physical effect obtained by reducing the thickness of the body 10 can also reduce the weight of the body 10, allowing the communication box to be easily installed, kept, and carried. It also can remarkably reduce the manufacturing costs of the communication box.

When the outer shape of the body 10 is manufactured to have the same size, an internal capacity of the communication box can be increased as compared with a conventional one and it is easier to mount another part in the communication box.

The present invention may be applied to a box for a base station as well as to a filter box, and in particular, the characteristics of the filter can be improved by increasing an internal capacity of the filter box.

As described above, according to the present invention, the body 10 is made thin to increase an internal capacity of the communication box, and the characteristics of the filter are improved due to an increase in capacity, and thus a filter which is plated with copper or not plated at all, rather than being plated with silver, to improve the characteristics of the filter can have more excellent characteristics as compared with a conventional filter plated with silver.

Thus, the present invention can exhibit defined characteristics even when plated with an inexpensive metal or without being plated at all, reducing manufacturing costs.

FIG. 2 shows an example of locating the centers of the coupling holes of the screw coupling portions 11 at central portions of the body 10 contacting the cover 20, and the screw coupling portions 11 have a structure in which semi-circular columns protrude from the inner and outer sides of the body 10.

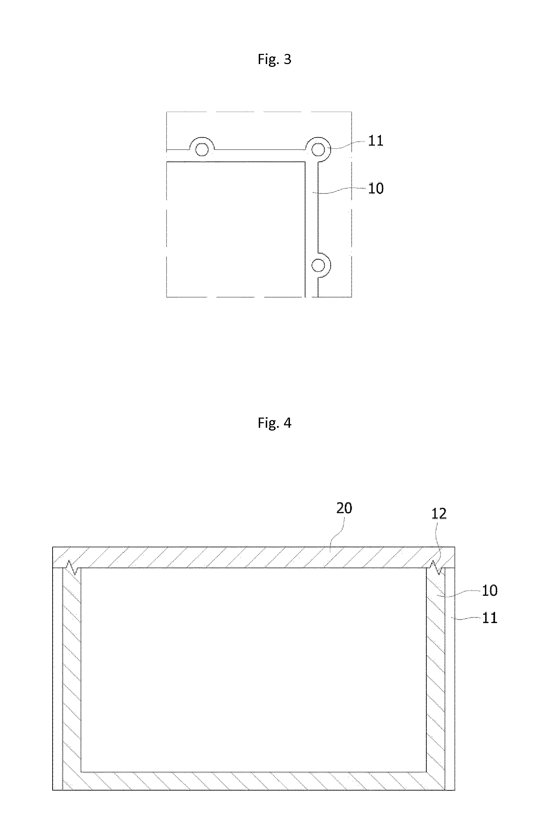

As another example, as illustrated in FIG. 3, the centers of the screw coupling portions 11 may be moved toward the outside as compared with in FIG. 1 such that the screw coupling portions 11 protrude only to the outside of the body 10.

According to the structure, the screw coupling portions 11 protruding in a semi-circular column shape are not formed on the inner surface of the body 10 such that the inner surface of the body 10 is flat, making it possible to increase an internal capacity of the communication box. It is apparent to those skilled in the art that screw coupling portions 11 may protrude only from the inner surface of the body 10. This is because when an outer size, i.e. a dimension of the body 10, is determined, since the dimension may be changed by protruding the screw coupling portions 11 to the outside, the screw coupling portions 11 protrude only to the inside.

The opened side of the body 10 having the screw coupling portions 11 is covered by the cover 20 and the screws 30 are coupled to the coupling holes 21 of the cover 20 and the screw coupling portions 11 to sealedly couple the cover 20 to the body 10.

FIG. 4 is a sectional view illustrating a coupling state of the communication box according to the embodiment of the present invention.

Referring to FIG. 4, a sealing portion 12 for preventing generation of contact nonlinearity is provided on a surface where the body 10 and the cover 20 contact each other.

As described above, although the screw coupling portions 11 to which the screws 30 are coupled maintain a complete sealed state to prevent generation of contact nonlinearity when the body 10 and the cover 20 are coupled to each other by the screws 30, fine gaps may be generated between the body 10 and the cover 20 at locations between the screw coupling portions 11, causing distortion of signals due to contact nonlinearity.

According to the present invention, in order to prevent this phenomenon, a step having a sharp end is formed at a central portion of the top end of the body 10 having a thickness (t) of 0.5 to 2.5 mm and a step enmeshed with the step of the body 10 is formed at a periphery of the bottom surface of the cover 20 such that the two steps are completely enmeshed when the screws 30 are coupled, preventing generation of contact nonlinearity.

The sealing portion 12 with the steps having sharp ends may be obtained by generating scratches on the surfaces with a sharp metal.

Although the steps are formed in both the body 10 and the cover 10, the steps may be formed in either the body 10 or the cover 20 to prevent generation of contact nonlinearity.

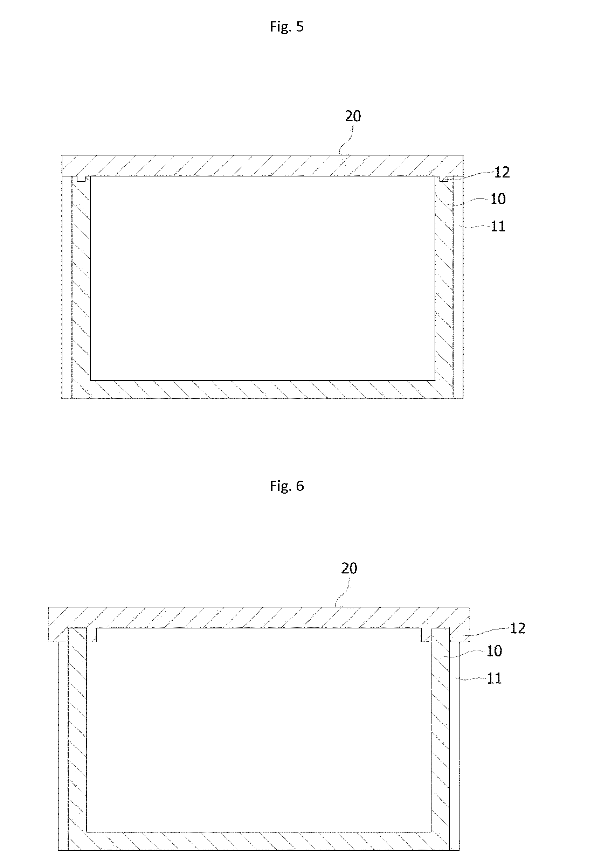

FIG. 5 is a sectional view illustrating another embodiment of the sealing portion 12.

Referring to FIG. 5, the sealing portion 12 according to another embodiment of the present invention has a structure in which uneven portions are formed in the body 10 and the cover 20 so as to be enmeshed with each other.

This structure also prevents generation of a fine gap between the body 10 and the cover 20 to prevent leakage and distortion of a signal through a fine gap when it is applied to a box for a communication filter.

FIG. 6 is a sectional view illustrating still another embodiment of the sealing portion 12.

Referring to FIG. 6, according to the embodiment of the present invention, an insertion groove into which a top end of the body 10 is inserted is formed at a periphery of the bottom surface of the cover 20.

That is, the cover 20 is press-fitted into the body 10 to be firmly fixed to the body 10, preventing generation of a fine gap.

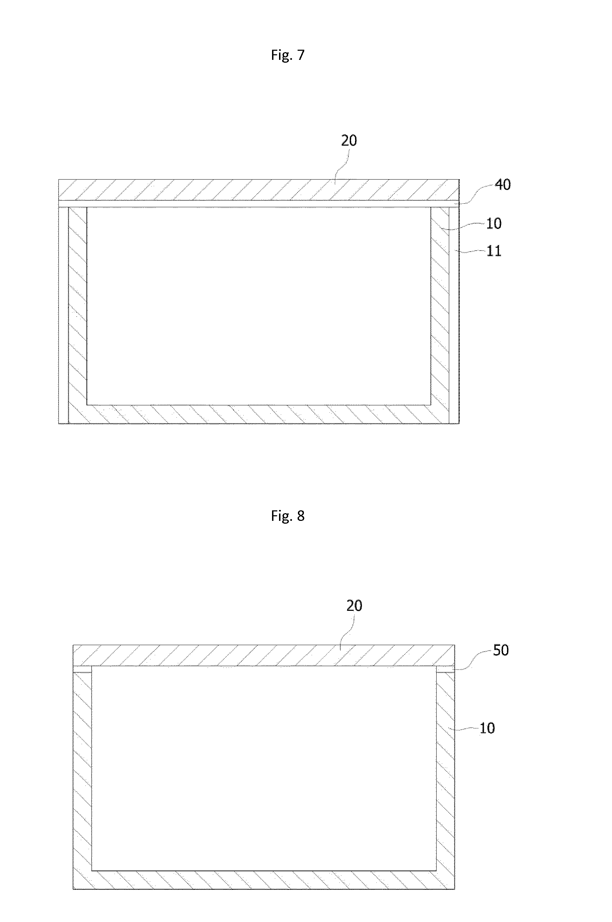

FIG. 7 is a sectional view of a communication box according to yet another embodiment of the present invention.

Referring to FIG. 7, the communication box according to the embodiment of the present invention further includes a seal 40 between the body 10 and the cover 20.

Preferably, a metal softer than the metal of the body 10 and the cover 20 may be used as the seal 40, and a metal having as similar characteristics as possible to those of the body 10 and the cover 20 may be used to prevent material nonlinearity due to the difference between the materials.

If the cover 20 is coupled to the body 10 using screws after the seal 40 is positioned between the body 10 and the cover, a surface of the seal 40 is pressed to some degree, making it possible to prevent generation of a fine gap between the seal 40 and the body 10 or the seal 40 and the cover 10.

Thus, the present invention can avoid generation of contact nonlinearity of the communication box using the seal 40, preventing distortion of a signal.

Although FIG. 7 illustrates that the seal 40 is provided at the entire bottom surface of the cover 20, the seal 40 may be machined in the form of a window frame to be applied only to a surface of the cover 20 contacting the body 20.

In this way, according to the present invention, the sealing portion 12 or the seal 40 may be applied between the body 10 and the cover 20 to prevent generation of contact nonlinearity, making it possible to reduce the number of screws 30 for coupling the cover 20 to the body 10.

That is, the sealing portion 12 and the seal 20 can prevent generation of contact nonlinearity in regions between the screws 30 where contact nonlinearity may be caused, allowing the screws 30 to be installed further spaced apart from each other, and thus the number of screws 30 can be remarkably reduced.

As the number of screws 30 is reduced, manufacturing costs of the communication box and costs and time for coupling the screws 30 are reduced, making it possible to enhance productivity.

Although it has been described that the body 10 and the cover 20 are coupled to each other by the screws 30, another aspect of the present invention suggests a structure in which the body 10 and the cover 20 are completely fixed and sealed without using the screws 30.

FIG. 8 is a sectional view of a communication box according to still another embodiment of the present invention.

Referring to FIG. 8, according to the communication box according to the embodiment of the present invention, unlike the above-described examples, the screw coupling portions 11 for coupling the screws 30 to the body 10 are not formed in the body 10 and the inner and outer surfaces of the body 10 are flat.

A thickness of the body 10 is 0.5 to 2.5 mm as in the preceding examples to improve thermal conductivity of the body and allow bonding in a short time, which will be described later in further detail.

A metallic sealing layer 50 having a melting point lower than those of the body 10 and the cover 20 is provided between contact surfaces of the body 10 and the cover 20.

As an example, the sealing layer 50 may be formed of an alloy of tin and bismuth whose melting point is 160 degrees Celsius. The sealing layer 50 is applied to the contact surfaces of a top end of the body 10 and the cover 20 in the form of paste, and the cover 20 is positioned on the body 20 with the sealing layer 50 being applied. Then, heat is applied to the entire communication box to melt and solidify the sealing layer 50 again and hence bond the cover 20 to the body 10.

The sealing layer 50 may be applied to the body 10, the cover 20, or both the body 10 and the cover 20, and a mask may be used to apply the sealing layer 50 only to a corresponding portion to rapidly apply a suitable amount of paste.

If the body 10 and the cover 20 positioned on the body 10 are introduced into a furnace or pass through the furnace using a conveyor after the paste is applied, the metal paste forming the sealing layer 50 is melted. Then, if the metal paste is cooled again, it bonds the cover 20 to the body 10.

Then, the sealing layer 50 should be melted and the body 10 and the cover 20 themselves should be heated to an appropriate temperature so that the body 10 and the cover 20 can be accurately bonded to each other by the sealing layer 50.

The body 10 and the cover 20 can be more easily bonded to each other when the sealing layer 50 is melted and cooled rapidly. If the melting time becomes longer, the melted sealing layer 50 may flow to a side or an additive (for example, flux) may be burned, making it difficult to bond the body 10 and the cover 20, and in particular a fine gap may be generated between the body 10 and the cover 20.

For this reason, the body 10 should be heated to an appropriate temperature in a short melting time. It has been described that the body 10 of the communication box according to the present invention has a thickness of 0.5 to 2.5 mm, and the thermal conduction characteristics of the body 10 itself are improved as compared with a body whose thickness is at least 3.5 mm and the body 10 is heated to a temperature suitable for bonding of the body 10 in a short melting time.

The thermal conduction of a medium is performed in all directions, and it can be easily seen that the thinner the body 10 serving as a medium is, the higher its thermal conductivity is.

The melting point of the sealing layer 50 should be lower than those of the body 10 and the cover 20 and should also be lower than the melting point of a metal used in another part located within the communication box where the body 10 and the cover 20 are coupled to each other.

This is because another part should be prevented from being thermally damaged when the sealing layer 50 is melted.

The body 10 and the cover 20 are preferably plated with a metal to easily bond the sealing layer 50.

The body 10 and the cover 20 are preferably plated with copper, and the body 10 and the cover 20 made of an aluminum alloy or a magnesium alloy and plated with copper can be easily bonded to each other, thus improving their characteristics.

The characteristics of the communication box according to the present invention become excellent as compared with a conventional communication box plated with silver even after it is plated with copper due to its improved characteristics obtained by making the thickness of the body 10 0.5 to 2.5 mm to increase its internal capacity.

When the body 10 plated with copper is bonded to the cover 20 using the sealing layer 50, although the plated copper is discolored if the body 10 is heated in a furnace for more than a predetermined time, the present invention can prevent discoloration of the plated copper by making the body 10 thin and reducing the time for bonding, thereby increasing the reliability of a process.

As described above, since the body 10 and the cover 20 can be firmly bonded to each other while preventing contact nonlinearity without using screws, manufacturing costs can be reduced as compared with a method in which screws are used, saving the time for coupling screws and hence enhancing productivity.

In addition, the body 10 and the cover 20 may be bonded to each other through a method of bonding the body 10 and the cover 20 without using screws such as laser welding to prevent generation of contact nonlinearity between the body 10 and the cover 20 while preventing generation of a fine gap.

Even when the sealing layer 50 is used without using screws, it may be applied to the sharp step structure, the insertion groove structure, or the enmeshed even surface structure provided in a contact surface of the body 10 and the cover 20.

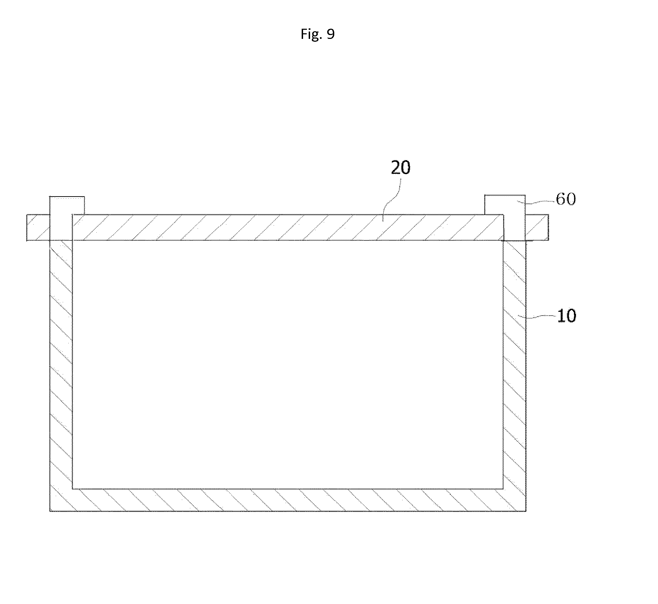

FIG. 9 is a sectional view of a communication box according to yet another embodiment of the present invention.

Referring to FIG. 9, in the communication box according to the embodiment of the present invention, a plurality of coupling bosses are formed on a top end of the body 10, and a plurality of through-holes 60 through which the coupling bosses 60 pass are formed in the cover 20.

In this structure, after the cover 20 is positioned on the body 10 such that the coupling bosses 60 of the body 10 pass through the through-holes of the cover 20, the coupling bosses 20 are caulked to couple the cover 20 to the body 10.

If a thickness of the body 10 is 0.5 to 2.5 mm, the coupling bosses 60 can be easily caulked, and the cover 20 can be easily attached and fixed to the body 10 even without using a bonding method such as screws or welding.

The coupling method using the coupling bosses 60 allows the cover 20 to be easily separated from the body 10 if necessary, making it possible to manufacture the communication box in a short time as compared with a method of using screws when embedded parts are repaired or exchanged.

As described above in detail, the present invention reduces an overall thickness of a communication box and improves characteristics of mobile communication parts, making the communication box light and reducing material costs.

While the invention has been shown and described with reference to certain exemplary embodiments thereof, it will be understood by those skilled in the art that various changes in form and details may be made therein without departing from the spirit and scope of the invention as defined by the appended claims.

### Industrial Applicability

The present invention also provides a communication box that improves characteristics of a mobile communication part due to an increase in an internal capacity thereof and shows excellent characteristics relative to a conventional mobile communication device plated with silver even if it is not plated at all or is plated with an inexpensive material.

## Claims

1. A communication box comprising:
a body, one side of which is opened, the opened side end of the body having a thickness of 0.5 to 2.5 mm; and
a cover for sealing the opened side of the body.

2. The communication box as claimed in claim 1, wherein screw coupling portions each having a thickness thicker than that of an end of the body are provided in the body and the cover is coupled to the screw coupling portions of the body using screws.

3. The communication box as claimed in claim 2, wherein the screw coupling portions vertically protrude in semi-circular column shapes on inner and outer sides of the body and centers of screw holes into which the screws are inserted are situated on a center line of the end of the body.

4. The communication box as claimed in claim 2, wherein the screw coupling portions vertically protrude in semi-circular column shapes on an inner or outer side of the body and centers of screw holes into which the screws are inserted are situated on an outer or inner side of a center line of the end of the body.

5. The communication box as claimed in any one of claims 1 to claim 4, further comprising a sealing portion in which steps each having a sharp end or uneven surfaces enmeshed with each other are formed on contact surfaces of the body and the cover.

6. The communication box as claimed in any one of claims 1 to claim 4, wherein an insertion groove into which a top end of the body is inserted is formed at a periphery of a bottom surface of the cover.

7. The communication box as claimed in any one of claims 1 to claim 4, wherein a seal softer than the body and the cover is provided between the body and the cover.

8. The communication box as claimed in claim 1, wherein the body and the cover are bonded to each other by a sealing layer having a melting point lower than those of the body and the cover.

9. The communication box as claimed in claim 8, wherein the sealing layer is formed by applying paste to one side of the body or the cover or sides of both the body and the cover so as to bond the body and the cover after the sealing layer is heated together with the body and the cover, melted, and cooled.

10. The communication box as claimed in claim 8 or claim 9, wherein surfaces of the body and the cover are plated with copper.

11. The communication box as claimed in claim 8 or claim 9, wherein the sealing layer is formed of an alloy of tin and bismuth.

12. The communication box as claimed in claim 1, wherein the body and the cover are laser-welded to each other.

13. The communication box as claimed in claim 1, wherein a plurality of coupling bosses are provided at an end of the body, and the cover is positioned on the body such that the coupling bosses pass through through-holes formed in the cover and the coupling bosses are caulked to fix the cover to the body.
